# EUROPEAN PATENT APPLICATION

(11) **EP 4 254 289 A1**
(43) Date of publication of application: **04.10.2023**
(21) Application number: 23164884.1
(22) Date of filing: 29.03.2023
(51) Int. Cl.: G06Q 10/087, G06Q 50/16

(54) **DATA MANAGEMENT SYSTEM, MANAGEMENT METHOD, AND MANAGEMENT PROGRAM**

(30) Priority: 29.03.2022 JP 2022053556
(71) Applicant: TOPCON CORPORATION, Tokyo 174-8580 (JP)
(72) Inventor: Doji, Atsushi, Itabashi-ku, Tokyo, 174-8580 (JP); Ito, Tadayuki, Itabashi-ku, Tokyo, 174-8580 (JP); Nishita, Nobuyuki, Itabashi-ku, Tokyo, 174-8580 (JP); Dohmoto, Takeshi, Itabashi-ku, Tokyo, 174-8580 (JP)
(74) Representative: dompatent von Kreisler Selting Werner - Partnerschaft von Patent- und Rechtsanwälten mbB

(57) **Abstract**

The present invention supports a routine work related to operation of a building to be performed by a manager of the building after completion of building construction. A management system (1) includes a completion database (3) storing, with respect to a completion member of a building, a member ID, member coordinates, and member attributes, an environment database (4) storing, with respect to environment conditions of the building, an environment acquisition result ID, environment acquisition coordinates, a work time, and environment attributes, a rule database (5) including a rule table (51) storing, with respect to an operation rule of the building, a rule ID of the operation rule, rule attributes of the operation rule, and a rule element of the operation rule, and an object table (52) storing the rule ID and related member attributes of a related member related to the rule ID, an operation database (6) including an operation rule table storing the rule ID, a member list of the related member, and an operation rule element based on the rule element, and an operation rule creating unit (7) configured to create the operation rule table.

## Description

### Technical Field

The present invention relates to a system, method, and program for maintaining and managing a building after completion.

### Background Art

In recent years, in the field of construction, utilization of a 3D model called BIM (Building Information Modeling) has been promoted. BIM is 3D modeling of a building to be reproduced on a computer, and a 3D model of each member can be created. BIM has been increasingly utilized at building design sites (planning, architectural design, facility design, design analysis, execution design, construction planning, and component manufacturing), however, it is said that there is a delay in utilization of BIM at building construction sites. Accordingly, the applicant has proposed a technology to utilize BIM at construction sites as described below. Based on Patent Literatures 1 to 4, a 3D model (hereinafter, referred to as "construction model") can be created in which information on a construction process is reflected in design BIM.

### Citation List

### Patent Literature

Patent Literature 1: Japanese Published Unexamined Patent Application No. 2021-89498
Patent Literature 2: Japanese Published Unexamined Patent Application No. 2021-099673
Patent Literature 3: Japanese Published Unexamined Patent Application No. 2021-124867
Patent Literature 4: Japanese Published Unexamined Patent Application No. 2021-131751

### Summary of Invention

### Technical Problem

However, it is considered that there is a delay in utilization of BIM not only during building construction but also after completion of building construction. After completion, it is necessary to maintain and manage the building and periodically inspect whether the building has been properly used. However, for this inspection, planning may be performed according to drawings and data at the time of completion of the building, and problems often occur in which current environment conditions of the building are not consistent with the completion drawing. As a result, problems with difficulty in planning or incorrect planning often arose.

The present invention was made in view of these problems, and an object thereof is to perform data management to support a routine work related to operation of a building to be performed by a manager of the building after completion of building construction.

### Solution to Problem

In order to solve the problems described above, a management system according to an aspect of the present invention includes a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other, an operation database including an operation rule table storing the rule ID, a member list of the related member, and an operation rule element based on the rule element, and an operation rule creating unit configured to create the operation rule table by associating data in the completion database, the environment database, and the rule database.

In the aspect described above, it is also preferable that the management system further includes an operation plan creating unit for creating one operation plan by using a selected plurality of the operation rules, wherein the operation plan creating unit creates the operation rule table with respect to the rule ID of each of the selected operation rules by using the operation rule creating unit, and in the operation database, creates an operation plan table storing a plan ID of the operation plan, the rule ID selected for the operation plan, plan attributes for managing whether an inspection according to the operation rule related to the rule ID has been executed, and a confirmation date and time for which execution of the inspection has been confirmed.

In the aspect described above, it is also preferable that the completion database stores member characteristics of the completion member, the environment database stores environment characteristics of the environment conditions, the rule database stores related member characteristics of the related member, and the operation rule creating unit creates the member list of the operation rule table from member characteristics.

In order to solve the problems described above, a management system according to another aspect of the present invention includes a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other, an operation database including an operation rule table storing the rule ID, a member list of the related member, and an operation rule element based on the rule element, and an operation rule operating unit configured to execute an inspection according to the operation rule by using the completion database, the environment database, and the operation rule table.

In the aspect described above, it is also preferable that the management system further includes an operation plan table and an operation plan operating unit for inspecting an operation plan including a plurality of the operation rules, wherein the operation plan table stores a plan ID of the operation plan, the rule ID of the operation rule selected for the operation plan, plan attributes for managing whether an inspection according to the operation rule of the rule ID has been executed, and a confirmation date and time for managing a date and time for which execution of the inspection has been confirmed, and is stored in the operation database, and the operation plan operating unit lists a record which has become an inspection date based on information on inspection frequency stored in the rule database from the environment database, executes an inspection according to the operation rule of the record which has become the inspection date by using the operation rule operating unit, and with respect to a record in which no violation has been detected, updates the plan attributes in the operation plan table to "Inspected" and stores the confirmation date and time.

In the aspect described above, it is also preferable that the management system further includes a notification management database storing the rule ID, a to-be-notified person ID of a to-be-notified person, and a contact address of the to-be-notified person, wherein with respect to the operation rule where violation has been detected in the inspection, based on the rule ID, by referring to the notification management database, an alert is transmitted to the to-be-notified person.

In the aspect described above, it is also preferable that, in the environment database, a record containing the work time from which a certain period of time has elapsed is transferred to a storage device different from a storage device of the environment database.

In the aspect described above, it is also preferable that, data in the environment database are divided into a first table containing the environment acquisition result ID, a coordinate point ID, and the environment acquisition coordinates, and a second table containing the environment acquisition result ID, the work time, the environment attributes, and a reference destination, the first table is transferred to a storage device different from a storage device of the environment database, and information on the different storage device is registered in the reference destination in the second table, and is read out from the reference destination as needed.

In the aspect described above, it is also preferable that the operation rule creating unit outputs a record created in the operation rule table as a report on request from a manager.

In the aspect described above, it is also preferable that the operation rule operating unit outputs a record which has been inspected for violation based on the operation rule table as a report on request from a manager.

In the aspect described above, it is also preferable that the operation plan creating unit outputs a record created in the operation plan table as a report on request from a manager.

In the aspect described above, it is also preferable that the operation plan operating unit outputs a record which has been inspected for violation based on the operation plan table as a report on request from a manager.

In order to solve the problems described above, a management method according to an aspect of the present invention includes the steps of: by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other, (A1) selecting one record from the rule IDs in the rule database, (B1) listing, by referring to the related member having the rule ID selected in the step (A1) from the object table, the completion member and/or the environment conditions corresponding to the related member attributes of the related member as a member list of the related member from the completion database and/or the environment database, (C1) listing all of the corresponding completion members and/or environment conditions by repeating the step (B1), and (D1) creating an operation rule table by bringing together the member list of the related members listed in the steps (B1) and (C1) with the rule ID selected in the step (A1) and the operation rule element based on the rule element of the rule ID selected in the step (A1) as one individual record, and storing the operation rule table in the operation database.

In the aspect described above, it is also preferable that the management method further includes the steps of: for creating one operation plan by using a selected plurality of the operation rules, (A3) selecting one record from the rule IDs in the rule database, (B3) creating, with respect to the rule ID selected in the step (A3), the operation rule table of the rule ID by performing the steps (A1) to (D1), (C3) creating a collection of the operation rules by the rule IDs necessary for the operation plan by repeating the steps (A3) to (B3), and (D3) creating an operation plan table by bringing together, with respect to the step (C3), a plan ID of the operation plan, the rule ID, plan attributes for managing whether an inspection according to the operation rule of the rule ID has been executed, and a confirmation date and time for managing a date and time for which execution of the inspection has been confirmed, as one individual record, and storing the operation plan table in the operation database.

In order to solve the problems described above, a management method according to another aspect of the present invention includes the steps of: by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member as the environment conditions related to the operation rule to associate the environment conditions and the operation rule with each other, an operation database including an operation rule table storing the rule ID, a member list of the related member, and an operation rule element based on the rule element, (A2) listing a specific record from the environment database, (B2) extracting a record containing the related member related to the environment attributes of the record listed in the step (A2) from the operation rule table, (C2) further extracting a record containing the related member paired in the member list in the record extracted in the step (B2), (D2) repeating the extraction in the step (C2) as many times as the number of records extracted in the step (B2), (E2) listing a record containing a work time ±N seconds from the work time listed in the step (A2) from the environment database, (F2) extracting a record containing the same environment attributes as those extracted in the step (B2) from records listed in the step (E2), (G2) calculating a distance between the environment acquisition coordinates listed in the step (A2) and the step (F2), (H2) calculating a moving speed from a difference between work times listed in the step (A2) and the step (E2) and the distance calculated in the step (G2), (I2) detecting whether the moving speed violates a condition described in the operation rule element in the operation rule table, and (J2) executing an inspection by repeating the steps (E2) to (I2) as many times as the number of records extracted in the step (D2).

In the aspect described above, it is also preferable that, for inspecting an operation plan including a plurality of the operation rules, the management method further includes the steps of: by transmitting and receiving information to and from the operation database configured to store an operation plan table storing a plan ID of the operation plan, the rule ID selected for the operation plan, plan attributes for managing whether an inspection according to the operation rule of the rule ID has been executed, and a confirmation date and time for managing a date and time for which execution of the inspection has been confirmed, (A4) listing a record in which the work time has become an inspection date from the environment database by comparing to inspection frequency stored in the rule database, (B4) detecting violation by performing the steps (A2) to (I2) for a record listed in the step (A4), and (C4) updating the plan attributes in the operation plan table with respect to a record in which no violation has been detected in the step (B4) to "Inspected" and storing the date and time of the inspection in the step (B4) as the confirmation date and time.

In order to solve the problems described above, a management method according to still another aspect of the present invention includes the steps of: by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other, an operation database including an operation rule table storing the rule ID, a member list of the related member, and an operation rule element based on the rule element, (A2') listing a specific record from the environment database, (B2') extracting a record containing the related member related to the environment attributes of the record listed in the step (A2') from the operation rule table, (C2') extracting, when the record listed in the step (A2') includes a record in which the environment acquisition coordinates of the record do not satisfy a condition described in the operation rule element in the operation rule table extracted in the step (B2'), the record as a corresponding record, (D2') executing an inspection by repeating the steps (B2') to (C2') as many times as the number of records listed in the step (A2'), and (E2') detecting the corresponding record detected through the steps (C2') and (D2') as violation.

In the aspect described above, it is also preferable that, for inspecting an operation plan including a plurality of the operation rules, the management method further includes the steps of: by transmitting and receiving information to and from the operation database configured to store an operation plan table storing a plan ID of the operation plan, the rule ID selected for the operation plan, plan attributes for managing whether an inspection according to the operation rule of the rule ID has been executed, and a confirmation date and time for managing a date and time for which execution of the inspection has been confirmed, (A4') listing a record in which the work time has become an inspection date from the environment database by comparing to inspection frequency stored in the rule database, (B4') detecting violation by performing the steps (A2') to (E2') for a record listed in the step (A4'), and (C4') updating the plan attributes in the operation plan table with respect to a record in which no violation has been detected in the step (B4') to "Inspected" and storing the date and time of execution of the inspection in the step (B4') as the confirmation date and time.

In the aspect described above, it is also preferable that the management method further includes the step of: by transmitting and receiving information to and from a notification management database storing the rule ID, a to-be-notified person ID of a to-be-notified person, and a contact address of the to-be-notified person, transmitting an alert to the to-be-notified person by referring to the notification management database based on the rule ID with respect to the operation rule where the violation has been detected after the step of detecting the violation.

It is also preferable that the management method according to the aspect described above is described as a computer program and execution of the computer program is enabled.

### Advantageous Effects of Invention

According to the data management system, management method, and management program of the present invention, after completion of building construction, data management to support a routine work related to operation of the building to be performed by a manager of the building can be performed.

### Brief Description of Drawings

FIG. 1 is a configuration block diagram of a management system 1 according to a first embodiment of the present invention.
FIG. 2 is a diagram illustrating an example of a completion database 3 in the same management system 1.
FIG. 3 is a diagram illustrating an example of an environment database 4 in the same management system 1.
FIG. 4 is a diagram illustrating an example of a rule database 5 in the same management system 1.
FIG. 5 is a diagram illustrating an example of an operation database 6 in the same management system 1.
FIG. 6 is a flowchart of a management method according to the first embodiment of the present invention.
FIG. 7 is a configuration block diagram of a management system 1' according to a second embodiment of the present invention.
FIG. 8 is a diagram illustrating an example of a notification management database 9 in the same management system 1'.
FIG. 9 is a flowchart of a management method according to the second embodiment of the present invention.
FIG. 10 is a work image view of the management method in FIG. 9.
FIG. 11 is another flowchart of the management method according to the second embodiment of the present invention.
FIG. 12 is a work image view of the management method in FIG. 11.
FIG. 13 is a configuration block diagram of a management system 10 according to a third embodiment of the present invention.
FIG. 14 is a flowchart of a management method according to the third embodiment of the present invention.
FIG. 15 is a configuration block diagram of a management system 10' according to a fourth embodiment of the present invention.
FIG. 16 is a flowchart of a management method according to the fourth embodiment of the present invention.
FIG. 17 is an image view of data compression processing according to a modification of the embodiments of the present invention.

### Description of Embodiments

Next, preferred embodiments of the present invention will be described with reference to the drawings. The same or equivalent components, members, and processes illustrated in the respective drawings, are provided with the same reference signs, and overlapping descriptions will be omitted as appropriate.

### <First Embodiment> Creation of Operation Rules

### (Configuration of Management System)

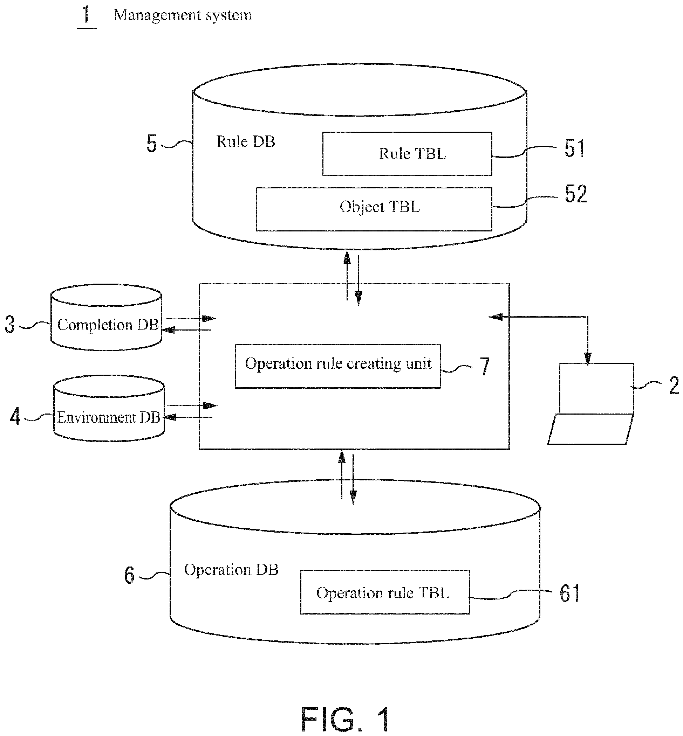

FIG. 1 is a configuration block diagram of a management system 1 according to a first embodiment of the present invention. The management system 1 is a system for creating an "operation rule" (described later). The management system 1 includes an input/output device 2, a completion database 3, an environment database 4, a rule database 5, an operation database 6, and an operation rule creating unit 7.

The input/output device 2 is a general-purpose personal computer, tablet terminal, etc., including at least an arithmetic unit, a storage unit, a communication unit, a display unit, and an operation unit, and can be operated by a manager.

The operation rule creating unit 7 (hereinafter, also referred to as a functional unit) is configured by electronic circuits such as a CPU (Central Processing Unit), an ASIC (Application Specific Integrated Circuit), and a PLD (Programmable Logic Device) such as an FPGA (Field Programmable Gate Array). The functional unit may be configured inside the input/output device 2 or configured by either separate external hardware/software. In the latter case, the functional unit can transmit and receive information to and from the input/output device 2 through a communication network.

The completion database 3, the environment database 4, the rule database 5, and the operation database 6 are stored in the same or different storage devices (server computers, etc.) configured to be capable of communicating with each other through a communication network. The storage device(s) can communicate with the functional unit, and transmit and receive information to and from the functional unit.

### (Completion Database)

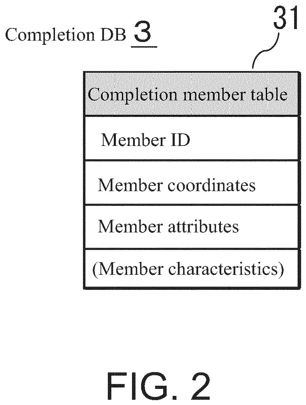

In the completion database 3, data on construction members at the time of completion (hereinafter, referred to as "completion members") of a building to be managed are stored. The completion database 3 includes a completion member table 31 in which, as illustrated in FIG. 2, with respect to each completion member, identification information of the completion member (member ID), coordinates of the completion member (member coordinates), information on attributes of the completion member (wall, slab, door, fire extinguisher..., etc. Hereinafter, referred to as "member attributes"), information on characteristics of the completion member (noncombustible, combustible, hazardous object..., etc. Hereinafter, referred to as "member characteristics") are associated with each other. The member IDs are uniquely set as, for example, with respect to completion members constituting a room, a wall A, a wall B, a wall C, a wall D, a slab (floor) A, a slab (ceiling) B, a door A, a door B.... The member attributes are an essential item, however, the member characteristics are an arbitrary item that is preferably provided (when provided, information extraction based on characteristics is possible).

In the completion member table 31, data on member coordinates can be created from coordinates on a completion drawing or coordinate data measured by a measuring device such as a scanner, however, the data is preferably created from a "construction model" created by the "design correction database" disclosed in Patent Literature 1, the "corrected construction plan database" disclosed in Patent Literature 2 or the work management system (hereinafter, referred to as "tool work management system") disclosed in Japanese Published Unexamined Patent Application No. 2021-173727 and the construction model creation system (hereinafter, referred to as "tool construction model creation system") disclosed in Japanese Published Unexamined Patent Application No. 2022-6508 proposed by the applicant. When the completion member table 31 is created from such a construction model, information on a "completion model" taking over information on member shapes, member coordinates, member attributes, member characteristics, manufacturers, prices, etc., registered in each member 3D model of the construction model (construction model at the time of completion. 3D model of a building at the time of completion, reproduced on a computer, and data from which a 3D model of each completion member can be created. The 3D model also includes shapes of surfaces, lines, and points.) can be stored.

### (Environment Database)

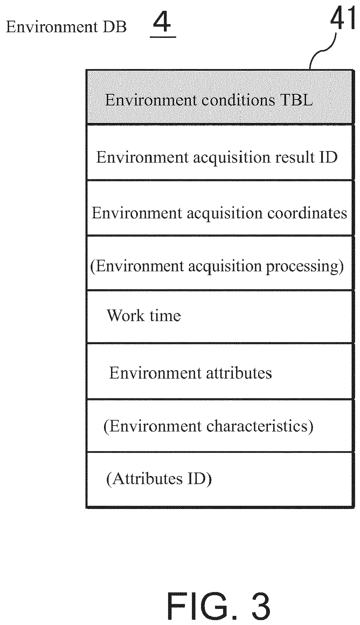

In the environment database 4, data on "environment conditions" of a building to be managed after completion is stored as needed. In this description, completion members after completion and objects related to the completion members (various objects other than the completion members, related to the completion members in terms of coordinates) are collectively referred to as "environment conditions." The environment database 4 includes an environment conditions table 41 in which, as illustrated in FIG. 3, identification information of environment conditions (environment acquisition result ID), coordinates of the environment conditions (environment acquisition coordinates), information (environment acquisition processing) on a measuring device (camera, scanner, total station, tool, etc.) that acquired the environment conditions, information (work time) on a time (month/date/year and hours:minutes:seconds) for which the environment conditions were acquired, information on attributes of the environment conditions (wall, slab, door, fire extinguisher, etc. When a member ID in the completion member table 31 is assigned to the environment acquisition coordinates, the member ID is also included. Hereinafter, referred to as "environment attributes." The environment attributes include not only attributes of the completion member but also attributes of an object (obstacle/mobile object (such as person/vehicle), etc.) related to the completion member), and information on characteristics of the environment conditions (noncombustible, combustible, hazardous object, etc. Hereinafter, referred to as "environment characteristics") are associated with each other. The environment attributes are an essential item, however, the environment characteristics are an arbitrary item which is preferably provided (when provided, information extraction based on the characteristics is possible). The environment acquisition processing is also an arbitrary item that is preferably provided (when provided, information extraction based on the environment acquiring device is possible) . In the environment conditions table 41, when the same environment attributes are assigned as environment attributes of different environment acquisition result IDs, identification information (attributes ID) for association based on the environment attributes may be stored.

In the environment conditions table 41, data on environment acquisition coordinates can be created from coordinate data measured by a measuring device such as a camera, scanner, or total station, and data on the environment attributes and the environment characteristics can be created from a known image identification means (such as machine learning type classifier), however, preferably, all items of the environment acquisition coordinates, environment acquisition processing, work time, environment attributes, and environment characteristics can be automatically created by using the technology to determine whether coordinates (object point) acquired by a measuring device are coordinates of a completion member or an object (shape calculation member) related to the completion member, disclosed in Patent Literature 3, and the above-described "tool work management system" and "tool construction model creation system."

### (Rule Database)

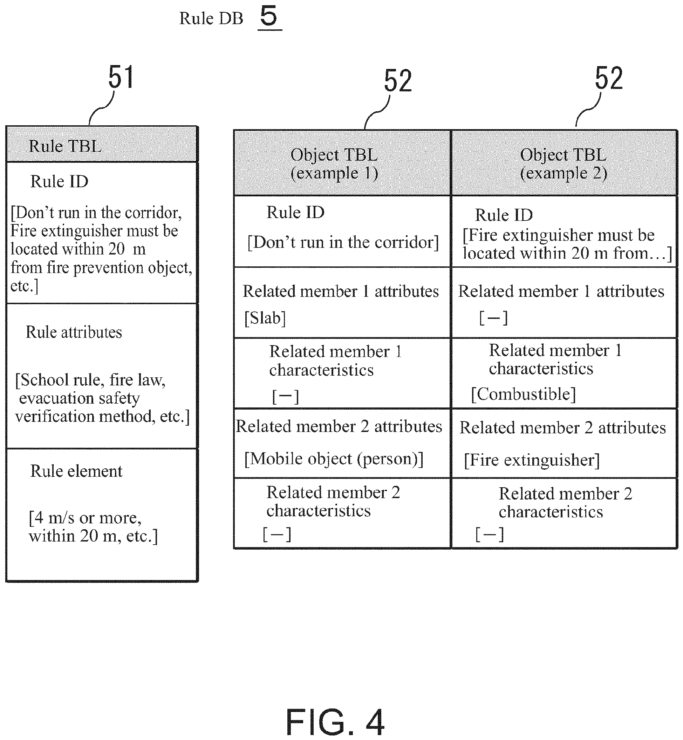

In the rule database 5, data on a law and/or a rule set by a manager (hereinafter, referred to as operation rules), necessary for operation of the building to be managed, are stored. The rule database 5 includes a rule table 51 in which, as illustrated in FIG. 4, at least identification information of an operation rule (rule ID), attributes of the operation rule (rule attributes), and an element of the operation rule (rule element) are associated with each other. The rule ID is set as an inspection item of the operation rule, for example, in the case of a school rule, "Don't run in the corridor," and in the case of a fire law, "Fire extinguisher must be located within 20 m from fire prevention object," or "External appearance of fire prevention system is without damage"..., etc. Rule attributes are attributes of an operation rule, for example, a fire law, an evacuation safety verification method, disaster prevention management, and school rule, etc. A rule element is a condition element in an inspection item of the operation rule, and is set as "4 m/sec or more" with respect to the inspection item "Don't run in the corridor," and "within 20 m" with respect to the inspection item "Fire extinguisher must be located within 20 m from fire prevention object," etc.

The rule database 5 includes an object table 52 for extracting an operation rule in relation to a completion member and/or environment conditions in the building. In the object table 52, a completion member and/or environment conditions related to a certain operation rule (rule ID) (hereinafter, a completion member and/or environment conditions stored in the object table 52 is referred to as "related member." The related member may be one related member 1, a pair of a related member 1 and a related member 2, or a set of three or more related members of the related member 1, a related member 2, a related member 3....) are stored in association with each other. In the object table 52, as illustrated in FIG. 4, a rule ID (linked to the rule table 51), attributes of a related member (wall, slab, door, fire extinguisher, etc. Hereinafter, referred to as "related member attributes"), and characteristics of the related member (noncombustible, combustible, to be handled with care, etc. Hereinafter, referred to as "related member characteristics") are stored in association with each other. The related member attributes are an essential item, however, the related member characteristics are an arbitrary item that is preferably provided (when provided, information extraction based on characteristics is possible).

In the rule database 5, it is preferable that a law name, a rule name, an inspection item, a related member in the inspection item and attributes and characteristics of the related member, and a condition element are read from management data in which an operation rule is described, or read by scanning a management document by using an OCR (Optical Character Reader), etc., and the manager or a rule database creating unit (functional unit) not illustrated stores the read data in corresponding portions in the rule table 51 and the object table 52.

### (Operation Database)

In the operation database 6, data for creating an operation rule, in which the completion database 3, the environment database 4, and the rule database 5 are associated based on an operation rule are recorded as needed in an operation rule table 61.

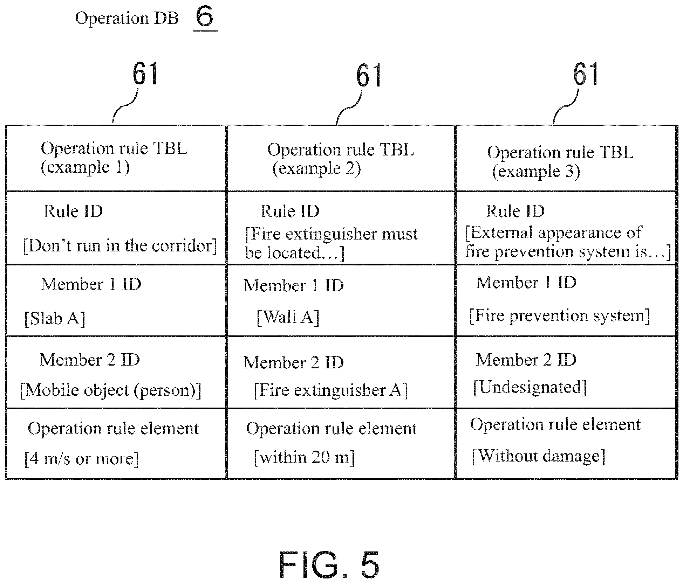

In the operation rule table 61, as illustrated in FIG. 5, a rule ID (linked to the rule database 5: rule table 51), a member list (described later) of related members, and an operation rule element (described later) necessary for executing an inspection according to the operation rule, are stored in association with each other. In the member list of related members, related members associated in the rule database 5: object table 52 are listed as a member 1 ID, a member 2 ID, a member 3 ID, and a member 4 ID.... Related members listed in the member list are member IDs, member attributes, and member characteristics in the completion database 3: completion member table 31, or environment attributes and environment characteristics in the environment database 4: environment conditions table 41. In the member list, when the related member in the object table 52 is blank, it is regarded as "Undesignated" (refer to example 1, example 2, and example 3 in FIG. 5). As an operation rule element, a condition element described as a rule element in the rule database 5: rule table 51 linked by the rule ID is stored.

The operation rule creating unit 7 creates the operation rule table 61 by associating data in the completion database 3, the environment database 4, and the rule database 5, and creates an "operation rule" based on the operation rule table 61. Details will be described in the management method to be described next.

### (Management Method: Operation Rule Creation)

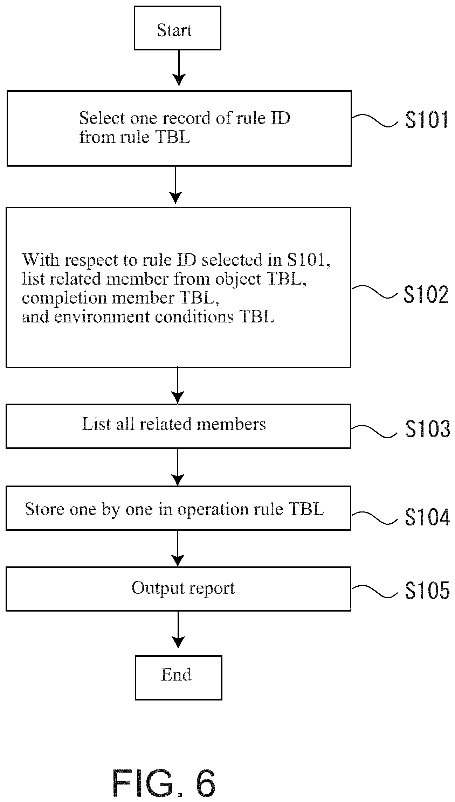

FIG. 6 is a flowchart of a management method according to the first embodiment of the present invention. This management method is a management method for creating an operation rule. As management processing is started, in Step S101, the operation rule creating unit 7 prompts a manager to select one record from rule IDs in the rule database 5: rule table 51. Next, in Step S102, by referring to a related member having the rule ID selected in Step S101 from the rule database 5: object table 52, the operation rule creating unit 7 lists, as a member list, a completion member and/or environment conditions corresponding to related member attributes of the related member from the completion member table 31 and/or the environment conditions table 41. In Step S103, the operation rule creating unit 7 lists all corresponding completion members and/or environment conditions by repeating Step S102. Next, in Step S104, the operation rule creating unit 7 stores the member list of the related members listed in Step S103, the rule ID selected in Step S101, and a condition element based on a rule element of the rule ID as one individual record in the operation rule table 61. As Step S105, on request from the manager, the operation rule creating unit 7 outputs the content of the record in the operation rule table 61 stored in Step S104 as a report to the input/output device 2. In Step S102 or S103, the operation rule creating unit 7 may list a completion member and/or environment conditions based on related member characteristics of the related member.

### (Examples of Management Method: Examples of Creation of Dynamic Operation Rule)

Example 1: Example of creation of operation rule based on school rule (Don't run in the corridor)
* Step S101: The rule ID "Don't run in the corridor" is selected from the rule table 51.
* Step S102: By referring to the object table 52, with respect to related member 1 attributes "Slab (corridor)," a member 1 ID "Slab (corridor) A" is listed from the completion member table 31, and with respect to related member 2 attributes "Mobile object (person)," a member 2 ID "Person" is listed from the environment conditions table 41.
* Step S104: A record containing the rule ID "Don't run in the corridor," the member 1 ID "Slab (corridor) A," the member 2 ID "Person," and "Operation rule element: Nobody moves at 4 m/s or more" is created in the operation rule table 61.
* Step S105: An operation rule such as "Nobody moves at 4 m/s or more in oo corridor (slab A)" is created.

Example 2: Example of creation of operation rule about working time limit
* Step S101: A rule ID "Nobody is allowed to stay in the building during hours except 7:00 to 22:00" is selected from the rule table 51.
* Steps S102 and S103: By referring to the object table 52, with respect to related member 1 attributes "Entire building, " member 1 IDs "Slab A, slab B, and slab C (floors of rooms)" are listed from the completion member table 31, and with respect to related member 2 attributes "Mobile object (person)," a member 2 ID "Person" is listed from the environment conditions table 41.
* Step S104: In the operation rule table 61, a record containing `rule ID "Nobody is allowed to stay in the building during hours except 7: 00 to 22: 00," member 1 ID "Slab A," member 2 ID "Person, " and "Operation rule element: Nobody is allowed to stay in the Slab A during hours except 7:00 to 22:00"' is created, and a record containing 'rule ID "Nobody is allowed to... 7:00 to 22:00," member 1 ID "Slab B," a member 2 ID "Person," and "Operation rule element: Nobody is allowed to stay... 7:00 to 22:00"' is created, and a record containing 'rule ID "Nobody is allowed to... 7: 00 to 22:00," member 1 ID "Slab C," member 2 ID "Person," "Operation rule element: Nobody is allowed to stay... 7:00 to 22:00"' is created.
* Step S105: An operation rule such as "Nobody is allowed to stay in oo room (Slab A), ΔΔ room (Slab B), and □□ room (Slab C) during hours except 7:00 to 22:00" is created.

Example 3: Example of creation of operation rule for evacuation drill
* Step S101: A Rule ID "Complete evacuation within 20 minutes from evacuation start" is selected from the rule table 51.
* Steps S102 and S103: By referring to the object table 52, with respect to related member 1 attributes "Entire building, " member 1 IDs "Slab A, Slab B, Slab C... (floors of respective rooms, respective corridors)" are listed, and with respect to related member 2 attributes "Mobile object (person)," a member 2 ID "Person" is listed from the environment conditions table 41.
* Step S104: A record containing 'rule ID "Complete evacuation within 20 minutes from evacuation start," member 1 ID "Slab A," member 2 ID "Person," and "Operation rule element: No body is allowed to stay in the building after 20 minutes from evacuation start"' is created. With respect to each of the member 1 ID "Slab B" and the member 1 ID "Slab C," one record is created in the same manner.
* Step S105: An operation rule such as "Nobody is allowed to stay in oo room (Slab A), ΔΔ room (Slab B), and □□ corridor (Slab C) after 20 minutes from evacuation start" is created.

Example 4: Example of creation of operation rule related to restoration to original state
* Step S101: A rule ID "Color change of wall paper when returned must be less than oo%" is selected from the rule table 51.
* Steps S102 and S103: By referring to the object table 52, with respect to related member 1 attributes "Wall," "Wall A, wall B, wall C..." are listed from the completion member table 31. Related member 2 attributes are blank.
* Step S104: A record containing 'rule ID "Color change of wall paper when returned must be less than oo%," member 1 ID "Wall A," "Operation rule element: "Color change of wall paper when returned must be less than oo%"' is created in the operation rule table 61. With respect to each of the member 1 ID "Wall B" and the member 1 ID "Wall C"..., one record is created in the same manner.
* Step S105: An operation rule such as "On wall A, wall B, and wall C, color change of wall paper when returned must be oo% or more" is created.

### (Examples of Management Method: Examples of Creation of Static Operation Rule)

Example 5: Example of creation of operation rule based on fire law (Fire extinguisher must be located within 20 m from fire prevention object)
* Step S101: A rule ID "Fire extinguisher must be located within 20 m from fire prevention object" is selected from the rule table 51.
* Steps S102 and S103: By referring to the object table 52, with respect to related member 1 attributes "Fire extinguisher," a member 1 ID "Fire extinguisher A" is listed from the completion member table 31, and with respect to related member 2 characteristics "combustible," member 2 IDs "Wall A, wall B" are listed from the completion member table 31.
* Step S104: In the operation rule table 61, a record containing `rule ID "Fire extinguisher must be located within 20 m from fire prevention object," member 1 ID "Fire extinguisher A," member 2 ID "Wall A," "Operation rule element: Fire extinguisher A must be present within 20 m from fire prevention object (wall A)"' is created. With respect to the member 2 ID "Wall B," a record is created in the same manner.
* Step S105: An operation rule such as "Fire extinguisher A must not be more than 20 m from fire prevention object (wall A), fire prevention object (wall B)" is created.

Example 6: Example of creation of operation rule based on train rail inspection rule (No obstacles allowed on rails)
* Step S101: A rule ID "No obstacles allowed on rails" is selected from the rule table 51.
* Step S102: By referring to the object table 52, with respect to related member 1 attributes "Rail," member 1 IDs "Rail A, rail B, rail C..." are listed from the completion member table 31, and with respect to related member 2 attributes "All objects," member 2 IDs "Obstacle, mobile object (person), mobile object (vehicle)..." are listed from the environment conditions table 41.
* Step S104: In the operation rule table 61, a record containing 'rule ID "No objects allowed on rails," member 1 ID "Rail A," member 2 IDs "Obstacle, mobile object (person), mobile object (vehicle) "' is created, and with respect to each of the member 1 ID "Rail B" and the member 1 ID "Rail C," one record is created in the same manner.
* Step S105: An operation rule such as "No obstacles, mobile objects (persons), and mobile objects (vehicles) are allowed on rail A, rail B, rail C..." is created.

Example 7: Example of creation of operation rule based on company rule (Speaker must be provided in meeting room)
* Step S101: A rule ID "Speaker must be provided in meeting room" is selected from the rule table 51.
* Step S102: By referring to the object table 52, with respect to related member 1 attributes "Meeting room," a member 1 ID "Slab B" is listed from the completion member table 31, and with respect to related member 2 attributes "Speaker," a member 2 ID "Speaker" is listed from the environment conditions table 41.
* Step S104: In the operation rule table 61, a record containing 'rule ID "Speaker must be provided in meeting room," member 1 ID "Slab B," member 2 ID "Speaker," and "Operation rule element: Speaker is present in slab B"' is created.
* Step S105: An operation rule such as "Speaker must be provided in meeting room (slab B)" is created.

As described above, according to the management system 1 and the management method of the first embodiment, the operation database 6 (operation rule table 61) is created by associating the completion database 3 for grasping a state of a building at the time of completion, the environment database 4 for grasping current environment conditions of the building, and the rule database 5 for grasping operation rules of the building. Therefore, based on the operation database 6 (operation rule table 61), an operation rule for properly operating the building can be automatically created upon reflecting the current environment conditions of the building.

### <Second Embodiment> Operation (Inspection) of Operation Rule

### (Configuration of Management System)

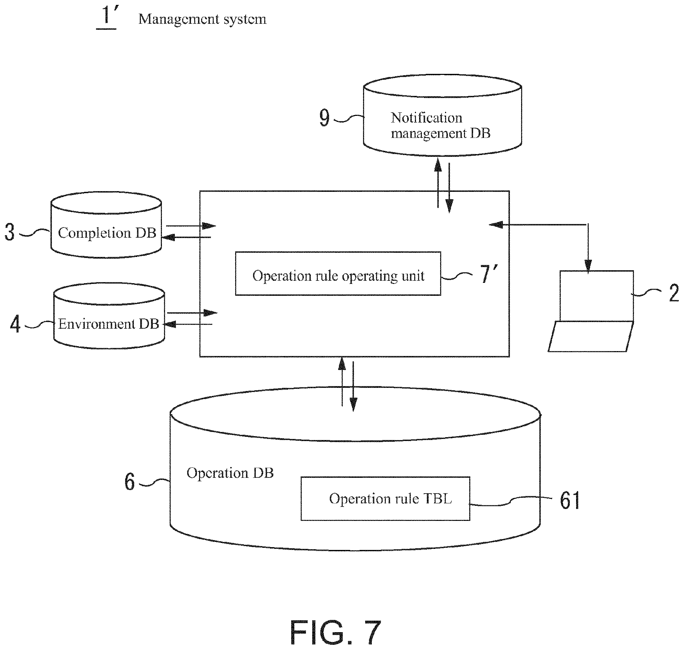

FIG. 7 is a configuration block diagram of a management system 1' according to a second embodiment of the present invention. The management system 1' is a system for operating an operation rule. The management system 1' includes the input/output device 2, the completion database 3, the environment database 4, the operation database 6 (operation rule table 61), an operation rule operating unit 7', and a notification management database 9.

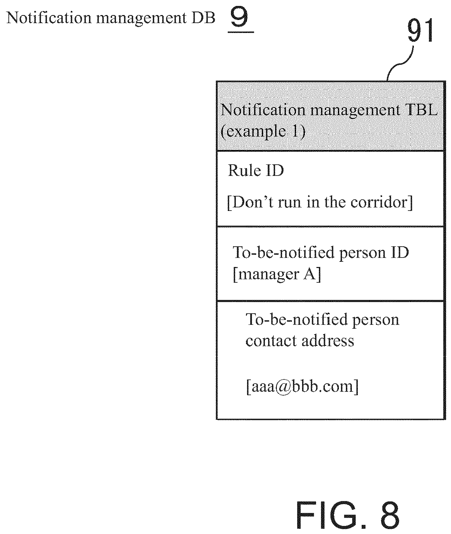

In the notification management database 9, data on a notification means for notification to a manager when violation of an operation rule is detected, is stored. The notification management database 9 includes, as illustrated in FIG. 8, a notification management table 91 in which a rule ID (linked to a rule ID in the operation database 6: operation rule table 61), identification information of a to-be-notified person (to-be-notified person ID), and a contact address of the to-be-notified person are stored in association with each other.

The operation rule operating unit 7' is a functional unit, and operates an operation rule (executes an inspection according to an operation rule) by using the completion database 3, the environment database 4, and the operation database 6 (operation rule table 61). Details will be described in a management method to be described next.

### (Management Method: Operation of Dynamic Operation Rule)

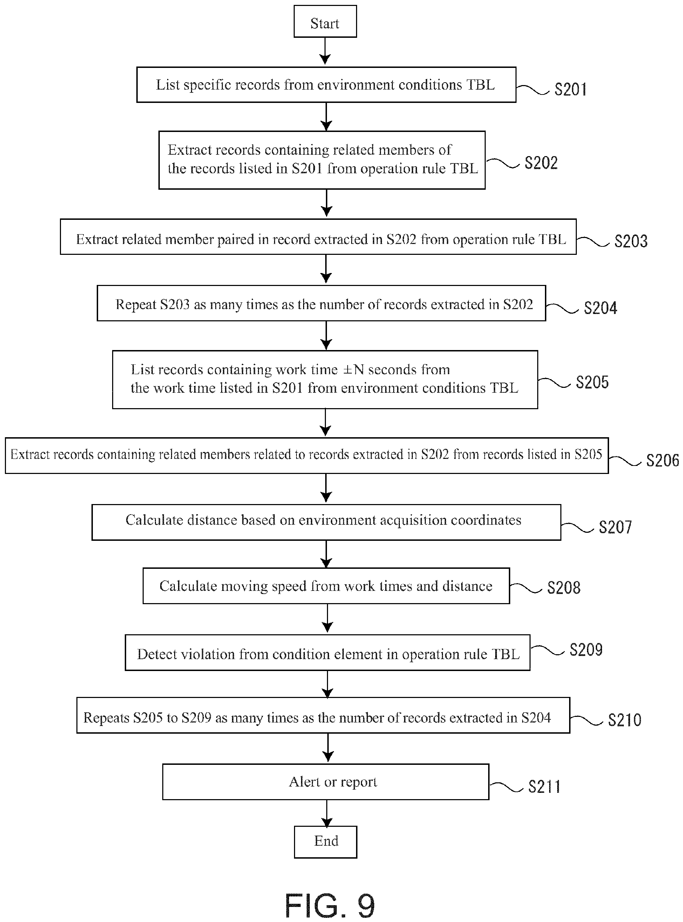

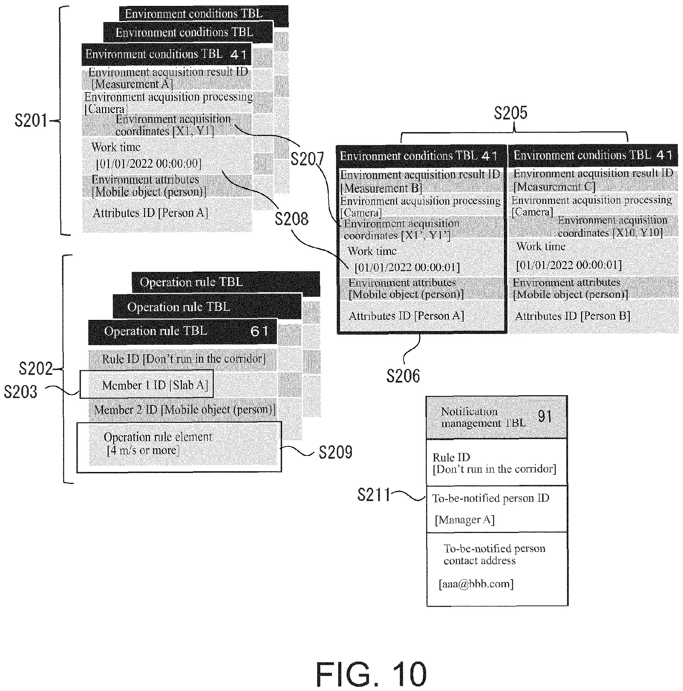

FIG. 9 is a flowchart of a management method according to the second embodiment of the present invention. This management method is a management method for operating (executing an inspection according to) a "dynamic" operation rule. FIG. 10 is a work image view of the same management method.

As management processing is started, in Step S201, the operation rule operating unit 7' lists specific records from the environment database 4. The specific records are listed by using a work time, environment attributes, or when an attributes ID is assigned, the attributes ID. Next, in Step S202, the operation rule operating unit 7' extracts records containing a related member related to the environment attributes of the record listed in Step S201 from the operation database 6: operation rule table 61. Next, in Step S203, the operation rule operating unit 7' further extracts a record containing a related member paired in the member list in the record extracted in Step S202. In Step S204, the operation rule operating unit 7' extracts (one or a plurality of) records by repeating the extraction in Step S203 as many times as the number of records extracted in Step S202. Next, in Step S205, by referring to the environment conditions table 41, the operation rule operating unit 7' lists records containing a work time ±N seconds from the work time listed in Step S201. Next, in Step S206, the operation rule operating unit 7' extracts a record having the same environment attributes as in Step S202 from the records listed in Step S205. Next, in Step S207, the operation rule operating unit 7' calculates a distance between environment acquisition coordinates of the record listed in Step S201 and the record extracted in Step S206. Next, in Step S208, the operation rule operating unit 7' calculates a moving speed from a difference between work times listed in Step S201 and Step S205 and the distance obtained in Step S207. Next, in Step S209, by referring to the operation rule element in the operation rule table 61, the operation rule operating unit 7' detects (inspects) whether the moving speed obtained in Step S208 violates the condition element. Next, in Step S210, the operation rule operating unit 7' executes the inspection by repeating Steps S205 to S209 as many times as the number of records extracted in Step S204. Next, in Step S211, the operation rule operating unit 7' notifies the manager of an alert, or outputs the content of the record inspected in Steps S209 and S210 as a report to the input/output device 2. For notification of the alert to the manager, by referring to the notification management database 9, the operation rule operating unit 7' transmits, for example, an alert message to a to-be-notified person contact address identified by the rule ID of the operation rule detected to have been violated in Step S209. In Step S202 or S206, the operation rule operating unit 7' may list records based on environment characteristics of the environment conditions. It is also preferable that, in Step S211, the operation rule operating unit 7' outputs a report in the form of a checklist for confirming a record in which violation has been detected and a record in which no violation has been detected.

### (Example of Management Method: Example of Operation of Dynamic Operation Rule)

Example 8: Example of inspection according to operation rule "Don't run in the corridor"
* Step S201: Records containing a specific work time (01/01/2022 00:00:00) are listed from the environment conditions table 41.
* Step S202: Records containing a related member (member 1 ID or member 2 ID: mobile object (person)) related to environment attributes (mobile object, person A) in S201 are extracted from the operation rule table 61.
* Step S203: A related member (member 1 ID: Slab A) paired in the member list in the record extracted in Step S202 is extracted.
* Step S205: From the environment conditions table 41, records containing a work time (01/01/2022 00:00:01) ±1 seconds from the specific work time are listed.
* Step S206: From the records listed in Step S205, a record containing the same "mobile object, person A" as in Step S202 is extracted.
* Step S207: A moving distance of the person A is calculated from the environment acquisition coordinates of the record in Step S201 and the record in Step S206.
* Step S208: A moving speed is calculated from a difference between the work times listed in Step S201 and Step S205 and the moving distance calculated in Step S207.
* Step S209: Violation is detected.
* Step S210: An alert is transmitted.

### (Management Method: Operation of Static Operation Rule)

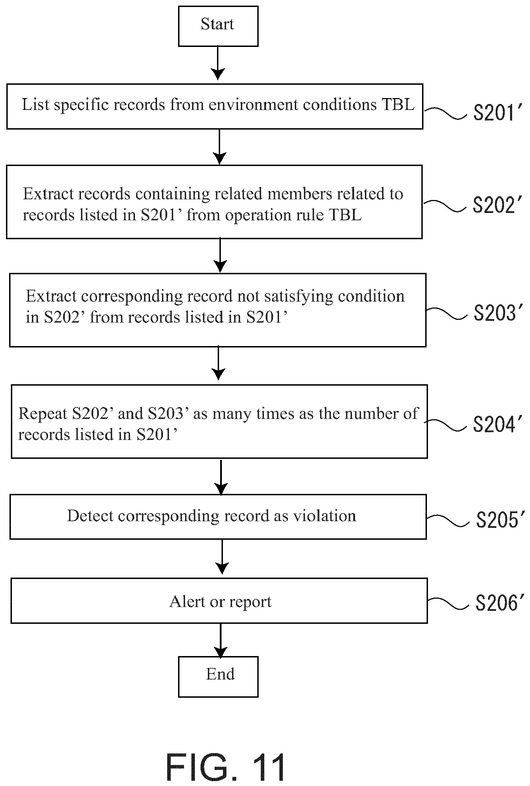

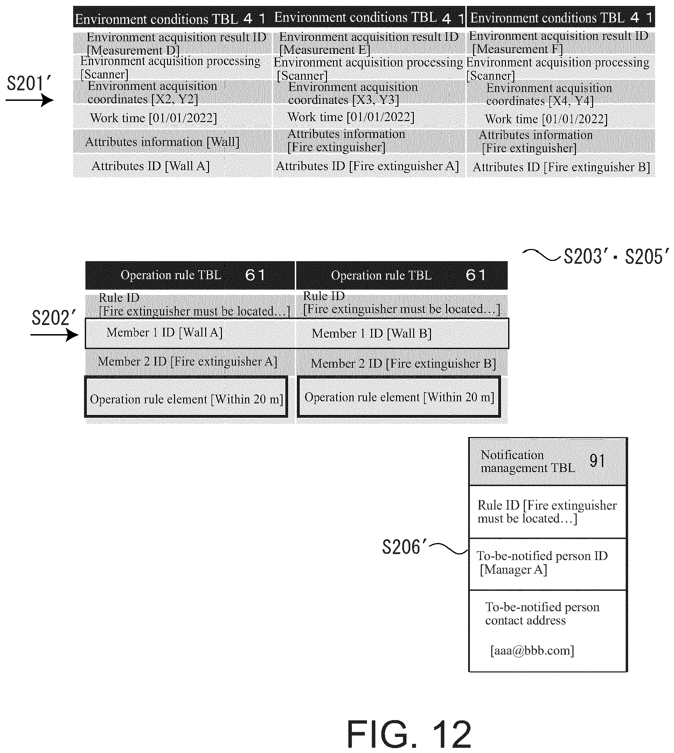

FIG. 11 is a flowchart of a management method according to the second embodiment of the present invention. This management method is a management method for operating a "static" operation rule. FIG. 12 is a work image view of the same management method.

As management processing is started, in Step S201' , the operation rule operating unit 7' lists specific records from the environment database 4. The specific records are listed by using a work time, environment attributes, or an attributes ID. Next, in Step S202', the operation rule operating unit 7' extracts records containing a related member related to the environment attributes of the record selected in Step S201' from the operation database 6. Next, in Step S203', when a record containing environment acquisition coordinates that do not satisfy the condition described in the operation rule element in the operation rule table 61 in Step S202' is included in the records of the environment conditions table 41 listed in Step S201' , the operation rule operating unit 7' extracts this record as a corresponding record. In Step S204', the operation rule operating unit 7' extracts (one or a plurality of) corresponding records by repeating the extractions in Steps S202' and S203' as many times as the number of records listed in Step S201' . Next, in Step S205' , when at least one corresponding record is extracted, the operation rule operating unit 7' detects it as violation. Next, in Step S206', the operation rule operating unit 7' notifies the manager of an alert or outputs the content of the record detected in Step S205' as a report to the input/output device 2. It is also possible that, in Step S202', the operation rule operating unit 7' lists records based on environment characteristics of the environment conditions. It is also preferable that, in Step S206', the operation rule operating unit 7' outputs a report in the form of a checklist for confirming a record in which violation has been detected and a record in which no violation has been detected.

### (Example of Management Method: Example of Operation of Static Operation Rule)

Example 9: Example of Inspection According to Operation Rule of Fire Law (Fire extinguisher must be located within 20 m from fire prevention object)
* Step S201': Records containing a specific work time (01/01/2022) are listed from the environment conditions table 41.
* Step S202' : Records containing a related member (member 1 ID or member 2 ID: wall) related to the environment attributes (wall) in Step S201' are extracted from the operation rule table 61.
* Step S203' : When a record not satisfying the distance condition described in the operation rule element (within 20m) extracted in Step S202' is included in the records listed in Step S201', this record is extracted as a corresponding record.
* Step S205': Violation is detected.
* Step S206': An alert is transmitted.

As described above, according to the management system 1' and the management method of the second embodiment, an inspection according to an operation rule can be automatically executed upon reflecting current environment conditions of the building by using the completion database 3, the environment database 4, and the operation database 6 (operation rule table 61) .

### <Third Embodiment> Operation Plan Creation

### (Configuration of Management System)

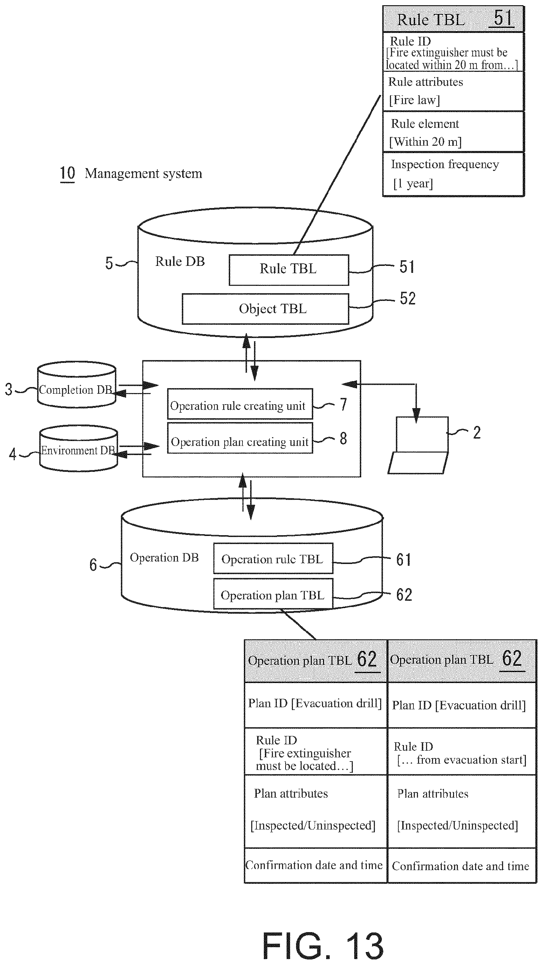

FIG. 13 is a configuration block diagram of a management system 10 according to a third embodiment of the present invention. The management system 10 is a system for creating a new plan (hereinafter, referred to as "operation plan") necessary for operating the building by using the collection of the operation rules described above. The management system 10 includes the input/output device 2, the completion database 3, the environment database 4, the rule database 5, the operation database 6, the operation rule creating unit 7, and an operation plan creating unit 8.

As illustrated in FIG. 13, in the rule database 5: rule table 51 of the present embodiment, information on inspection frequency is also stored in each record. In the operation database 6 of the present embodiment, the operation rule table 61 and an operation plan table 62 are stored. The operation plan table 62 is for data management of a plurality of operation rules as one operation plan linked by one plan ID. In the operation plan table 62, a rule ID (linked to a rule ID in the operation rule table 61) of an operation rule selected for an operation plan to which a plan ID (fire law, evacuation safety verification method, disaster prevention management, and school rule, etc., based on rule attributes in the rule database 5: rule table 51) is assigned, and plan attributes for managing whether an inspection according to the operation rule selected for the operation plan has been executed or not executed, and a date and time (confirmation date and time) for which execution of the inspection according to the operation rule selected for the operation plan has been confirmed, are stored in association with each other.

The operation plan creating unit 8 is a functional unit, and creates a new operation plan by a collection of operation rules by using the operation rule creating unit 7. Details will be described in a management method to be described next.

### (Management Method: Operation Plan Creation)

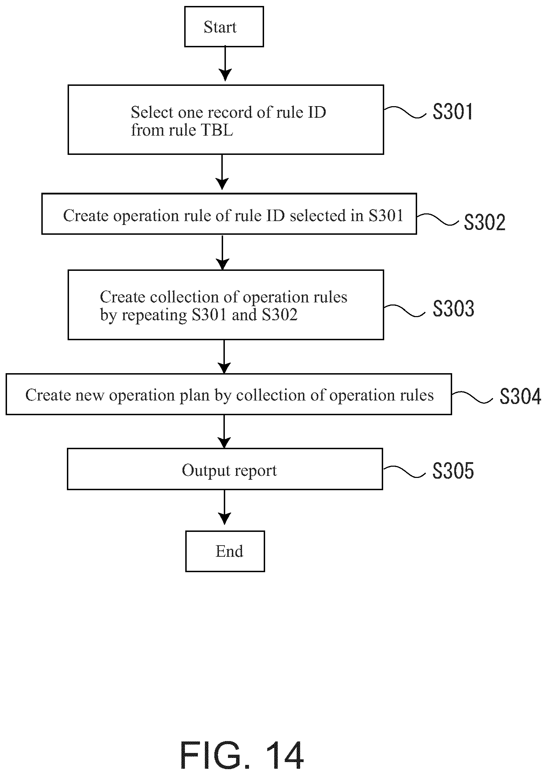

FIG. 14 is a flowchart of a management method according to the third embodiment of the present invention. This management method is a management method for creating an operation plan. As management processing is started, in Step S301, the operation plan creating unit 8 prompts the manager to select one rule ID that the manager desires to incorporate in the operation plan from the rule ID of the rule database 5: rule table 51. Next, in Step S302, the operation plan creating unit 8 causes the operation rule creating unit 7 to create the operation rule table 61 related to the rule ID selected in Step S301 (refer to the first embodiment). In Step S303, the operation plan creating unit 8 makes a collection of operation rules based on rule IDs necessary for the operation plan by repeating Steps S301 and S302. Next, in Step S304, the operation plan creating unit 8 assigns common identification information (plan ID) to the collection of operation rules made in Step S303, and stores each rule ID, plan attributes, and a confirmation date and time as one individual record in the operation plan table 62. As Step S305, the operation plan creating unit 8 outputs the content of the record in the operation plan table 62 stored in Step S304 as a report to the input/output device 2 on request from the manager.

As described above, according to the management system 10 and the management method of the third embodiment, by arbitrarily collecting operation rules that the manager desires to employ, a new operation plan for properly operating the building can be easily created.

### <Fourth Embodiment> Operation (Inspection) of Operation Plan

### (Configuration of Management System)

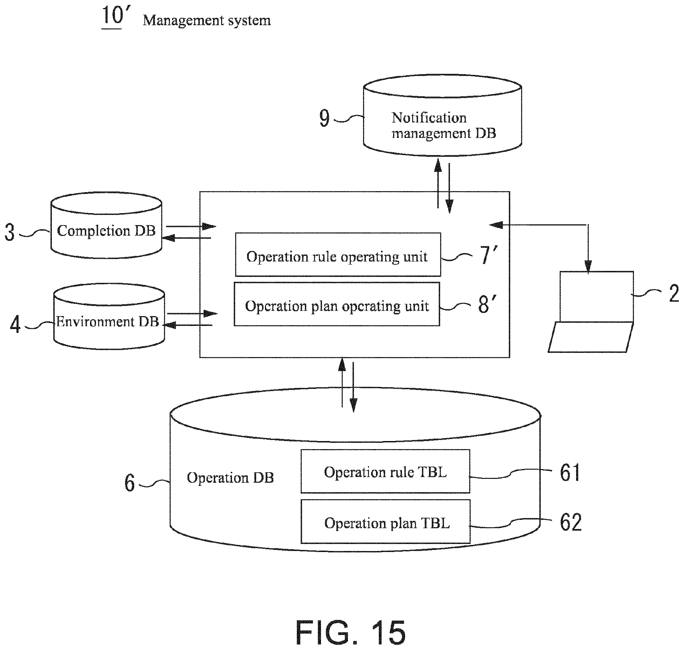

FIG. 15 is a configuration block diagram of a management system 10' according to a fourth embodiment of the present invention. The management system 10' is a system for operating an operation plan. The management system 10' includes the input/output device 2, the completion database 3, the environment database 4, the operation database 6 (operation rule table 61, operation plan table 62), the operation rule operating unit 7', an operation plan operating unit 8', and the notification management database 9.

The operation plan operating unit 8' is a functional unit, and operates an operation plan (executes an inspection according to operation rule) by using the completion database 3, the environment database 4, and the operation database 6. Details will be described in a management method to be described next.

### (Management Method: Operation of Operation Plan)

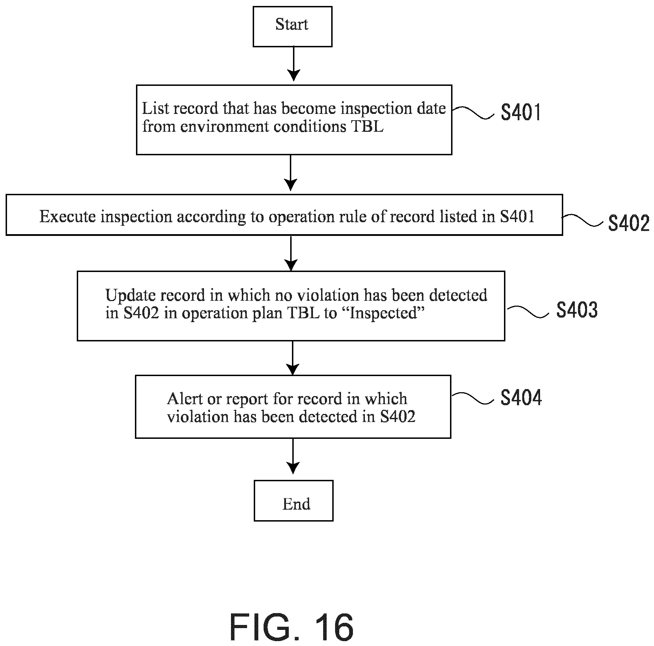

FIG. 16 is a flowchart of a management method according to the fourth embodiment of the present invention. This management method is a management method for operating an operation plan. As management processing is started, in Step S401, from the environment database 4: environment conditions table 41, the operation plan operating unit 8' lists a record in which the work time has become an inspection date as compared with inspection frequency in the rule database 5: rule table 51. Next, in Step S402, the operation plan operating unit 8' causes the operation rule operating unit 7' to execute an inspection according to an operation rule related to the record listed in Step S401 (refer to the second embodiment) to detect violation. Next, in Step S403, concerning a record in which no violation has been detected in Step S402 in the operation rule table 61, the operation plan operating unit 8' updates plan attributes in the operation plan table 62 linked by a rule ID to "Inspected," and stores a date and time for which the processing of S402 has been executed as a "confirmation date and time." Next, in Step S404, concerning a record in which violation has been detected in Step S402 in the operation rule table 61, the operation plan operating unit 8' notifies the manager of an alert by referring to the notification management database 9, or outputs the content of the record inspected for violation in Step S403 as a report to the input/output device 2. In Step S404, it is also preferable that the operation plan operating unit 8' outputs a report in the form of a checklist for confirmation based on the plan attributes "Inspected" or "Uninspected" in the operation plan table 62. Further, it is also preferable that the operation plan operating unit 8' transmits an alert or outputs a report of a record in which an inspection date has passed while the plan attributes are still "Uninspected" based on the inspection frequency in the rule table 51.

As described above, according to the management system 1' and the management method of the fourth embodiment, an operation plan arbitrarily created by the manager can be automatically inspected by using the completion database 3, the environment database 4, and the operation database 6 (operation plan table 62).

As described above, according to the embodiments of the present invention, creation of an operation rule, operation (inspection) of an operation rule, creation of an operation plan, and operation (inspection) of an operation plan are automatically performed. In many cases, these creation of rules or plans and inspection of rules or plans to inspect whether a building is properly operated seem to be managed in an analog manner by an owner of the building, however, these are automated as described above, so that a routine work related to operation of the building can be significantly shortened.

### <Modification>

Next, a preferred modification applicable to the embodiments described above will be described. In the environment database 4: environment conditions table 41, depending on an operation rule, information accumulation on a second-by-second basis is necessary in, for example, Example 8, and data compression processing is necessary.

### (1) Data Compression Processing (No. 1)

The operation rule operating unit 7' or the operation plan operating unit 8' extracts a record containing a work time from which a certain period of time (for example, 7 days) has passed from the environment conditions table 41, and transfers this record to a storage device (large-capacity storage server, etc.) separate from the server computer storing the environment database 4.

### (2) Data Compression Processing (No. 2)

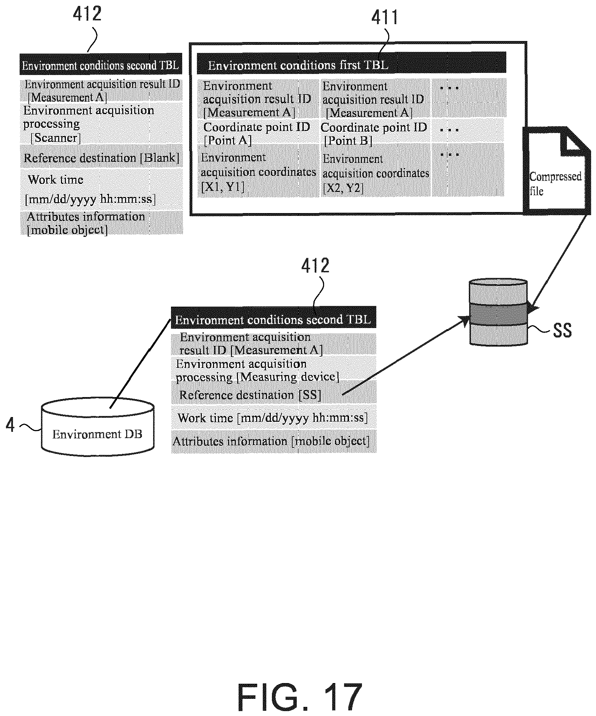

The environment conditions table 41 is normalized. FIG. 17 is an image view of data compression processing of the same. The environment conditions table 41 is divided into a first table 411 containing an environment acquisition result ID, a coordinate point ID, and environment acquisition coordinates, and a second table 412 containing an environment acquisition result ID, environment acquisition processing, a work time, environment attributes, and a reference destination, the first table 411 is converted into a compressed file and transferred to a storage device SS (large-capacity storage server, etc.) separate from the storage device storing the environment database 4, and in the second table 412, information on a reference destination (storage destination) for the compressed file of the first table 411 is registered, and is read as needed from the reference destination and used.

In the modification described above, by configuring the environment database 4, operations according to the embodiments described above become smoother.

Preferred embodiments and modifications of the present invention have been described above, and the embodiments and modifications can be combined based on the knowledge of a person skilled in the art, and such a combined embodiment is also included in the scope of the present invention.

### Reference Signs List

1, 1', 10, 10': Management system
2: Input/output device
3: Completion database
31: Completion member table
4: Environment database
41: Environment conditions table
5: Rule database
51: Rule table
52: Object table
6: Operation database
61: Operation rule table
62: Operation plan table
7: Operation rule creating unit
7': Operation rule operating unit
8: Operation plan creating unit
8': Operation plan operating unit
9: Notification management database
91: Notification management table

## Claims

1. A management system comprising:
a completion database storing, with respect to a completion member of a building to be managed, at least a member ID, member coordinates, and member attributes;
an environment database storing, with respect to environment conditions of the building including the completion member after completion or an object related to the completion member, at least an environment acquisition result ID, environment acquisition coordinates, a work time, and environment attributes;
a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other;
an operation database including an operation rule table storing the rule ID, a member list of the related member, and an operation rule element based on the rule element; and
an operation rule creating unit configured to create the operation rule table by associating data in the completion database, the environment database, and the rule database.

2. A management method comprising the steps of:
by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other,
(A1) selecting one record from the rule IDs in the rule database;
(B1) listing, by referring to the related member having the rule ID selected in the step (A1) from the object table, the completion member and/or the environment conditions corresponding to the related member attributes of the related member as a member list of the related member from the completion database and/or the environment database;
(C1) listing all of the corresponding completion members and/or environment conditions by repeating the step (B1); and
(D1) creating an operation rule table by bringing together the member list of the related members listed in the steps (B1) and (C1) with the rule ID selected in the step (A1) and the operation rule element based on the rule element of the rule ID selected in the step (A1) as one individual record, and storing the operation rule table in the operation database.

3. A management system comprising:
a completion database storing, with respect to a completion member of a building to be managed, at least a member ID, member coordinates, and member attributes;
an environment database storing, with respect to environment conditions of the building including the completion member after completion or an object related to the completion member, at least an environment acquisition result ID, environment acquisition coordinates, a work time, and environment attributes;
a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other;
an operation database including an operation rule table storing the rule ID, a member list of the related member, and an operation rule element based on the rule element; and
an operation rule operating unit configured to execute an inspection according to the operation rule by using the completion database, the environment database, and the operation rule table.

4. A management method comprising the steps of:
by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member as the environment conditions related to the operation rule to associate the environment conditions and the operation rule with each other, an operation database including an operation rule table storing the rule ID, a member list of the related member, and an operation rule element based on the rule element,
(A2) listing a specific record from the environment database;
(B2) extracting a record containing the related member related to the environment attributes of the record listed in the step (A2) from the operation rule table;
(C2) further extracting a record containing the related member paired in the member list in the record extracted in the step (B2);
(D2) repeating the extraction in the step (C2) as many times as the number of records extracted in the step (B2);
(E2) listing a record containing a work time ±N seconds from the work time listed in the step (A2) from the environment database;
(F2) extracting a record containing the same environment attributes as those extracted in the step (B2) from records listed in the step (E2);
(G2) calculating a distance between the environment acquisition coordinates listed in the step (A2) and the step (F2) ;
(H2) calculating a moving speed from a difference between work times listed in the step (A2) and the step (E2) and the distance calculated in the step (G2);
(I2) detecting whether the moving speed violates a condition described in the operation rule element in the operation rule table; and
(J2) executing an inspection by repeating the steps (E2) to (12) as many times as the number of records extracted in the step (D2).

5. A management method comprising the steps of:
by transmitting and receiving information to and from a completion database storing, with respect to a completion member of a building to be managed, at least a member ID, member coordinates, and member attributes, an environment database storing, with respect to environment conditions of the building including the completion member after completion or an object related to the completion member, at least an environment acquisition result ID, environment acquisition coordinates, a work time, and environment attributes, a rule database including a rule table storing, with respect to an operation rule of the building, at least a rule ID of the operation rule, rule attributes of the operation rule, and a rule element of the operation rule, and an object table storing at least the rule ID and related member attributes of a related member related to the rule ID to associate the completion member, the environment conditions, and the operation rule with each other, an operation database including an operation rule table storing the rule ID, a member list of the related member, and an operation rule element based on the rule element,
(A2') listing a specific record from the environment database;
(B2') extracting a record containing the related member related to the environment attributes of the record listed in the step (A2') from the operation rule table;
(C2') extracting, when the record listed in the step (A2') includes a record in which the environment acquisition coordinates of the record do not satisfy a condition described in the operation rule element in the operation rule table extracted in the step (B2'), the record as a corresponding record;
(D2') executing an inspection by repeating the steps (B2') to (C2') as many times as the number of records listed in the step (A2'), and
(E2') detecting the corresponding record detected through the steps (C2') and (D2') as violation.

6. The management system according to Claim 1, further comprising:
an operation plan creating unit for creating one operation plan by using a selected plurality of the operation rules, wherein
the operation plan creating unit creates the operation rule table with respect to the rule ID of each of the selected operation rules by using the operation rule creating unit, and
in the operation database, creates an operation plan table storing a plan ID of the operation plan, the rule ID selected for the operation plan, plan attributes for managing whether an inspection according to the operation rule related to the rule ID has been executed, and a confirmation date and time for which execution of the inspection has been confirmed.

7. The management method according to Claim 2, further comprising the steps of:
for creating one operation plan by using a selected plurality of the operation rules,
(A3) selecting one record from the rule IDs in the rule database;
(B3) creating, with respect to the rule ID selected in the step (A3), the operation rule table of the rule ID by performing the steps (A1) to (D1);
(C3) creating a collection of the operation rules by the rule IDs necessary for the operation plan by repeating the steps (A3) to (B3); and
(D3) creating an operation plan table by bringing together, with respect to the step (C3), a plan ID of the operation plan, the rule ID, plan attributes for managing whether an inspection according to the operation rule of the rule ID has been executed, and a confirmation date and time for managing a date and time for which execution of the inspection has been confirmed, as one individual record, and storing the operation plan table in the operation database.

8. The management system according to Claim 3, further comprising:
an operation plan table and an operation plan operating unit for inspecting an operation plan including a plurality of the operation rules, wherein
the operation plan table
stores a plan ID of the operation plan, the rule ID of the operation rule selected for the operation plan, plan attributes for managing whether an inspection according to the operation rule of the rule ID has been executed, and a confirmation date and time for managing a date and time for which execution of the inspection has been confirmed, and is stored in the operation database, and
the operation plan operating unit
lists a record which has become an inspection date based on information on inspection frequency stored in the rule database from the environment database, and
executes an inspection according to the operation rule of the record which has become the inspection date by using the operation rule operating unit, and with respect to a record in which no violation has been detected, updates the plan attributes in the operation plan table to "Inspected" and stores the confirmation date and time.

9. The management method according to Claim 4, further comprising the steps of:
for inspecting an operation plan including a plurality of the operation rules,
by transmitting and receiving information to and from the operation database configured to store an operation plan table storing a plan ID of the operation plan, the rule ID selected for the operation plan, plan attributes for managing whether an inspection according to the operation rule of the rule ID has been executed, and a confirmation date and time for managing a date and time for which execution of the inspection has been confirmed,
(A4) listing a record in which the work time has become an inspection date from the environment database by comparing to inspection frequency stored in the rule database;
(B4) detecting violation by performing the steps (A2) to (I2) for a record listed in the step (A4); and
(C4) updating the plan attributes in the operation plan table with respect to a record in which no violation has been detected in the step (B4) to "Inspected" and storing the date and time of the inspection in the step (B4) as the confirmation date and time.

10. The management method according to Claim 5, further comprising the steps of:
for inspecting an operation plan including a plurality of the operation rules,
by transmitting and receiving information to and from the operation database configured to store an operation plan table storing a plan ID of the operation plan, the rule ID selected for the operation plan, plan attributes for managing whether an inspection according to the operation rule of the rule ID has been executed, and a confirmation date and time for managing a date and time for which execution of the inspection has been confirmed,
(A4') listing a record in which the work time has become an inspection date from the environment database by comparing to inspection frequency stored in the rule database;
(B4') detecting violation by performing the steps (A2') to (E2') for a record listed in the step (A4'); and
(C4') updating the plan attributes in the operation plan table with respect to a record in which no violation has been detected in the step (B4') to "Inspected" and storing the date and time of execution of the inspection in the step (B4') as the confirmation date and time.

11. The management system according to Claim 3 or 8, further comprising:
a notification management database storing the rule ID, a to-be-notified person ID of a to-be-notified person, and a contact address of the to-be-notified person, wherein
with respect to the operation rule where violation has been detected in the inspection, based on the rule ID, by referring to the notification management database, an alert is transmitted to the to-be-notified person.

12. The management method according to any one of Claims 4, 5, 9, and 10, further comprising the step of:
by transmitting and receiving information to and from a notification management database storing the rule ID, a to-be-notified person ID of a to-be-notified person, and a contact address of the to-be-notified person,
transmitting an alert to the to-be-notified person by referring to the notification management database based on the rule ID with respect to the operation rule where the violation has been detected after the step of detecting the violation.

13. The management method according to any one of Claims 1, 3, 6, and 8, wherein
in the environment database, a record containing the work time from which a certain period of time has elapsed is transferred to a storage device different from a storage device of the environment database.

14. The management system according to any one of Claims 1, 3, 6, and 8, wherein
data in the environment database are divided into a first table containing the environment acquisition result ID, a coordinate point ID, and the environment acquisition coordinates, and a second table containing the environment acquisition result ID, the work time, the environment attributes, and a reference destination, the first table is transferred to a storage device different from a storage device of the environment database, and information on the different storage device is registered in the reference destination in the second table, and is read out from the reference destination as needed.

15. The management system according to Claim 1 or 6, wherein the operation rule creating unit outputs a record created in the operation rule table as a report on request from a manager.

16. The management system according to Claim 3 or 8, wherein the operation rule operating unit outputs a record which has been inspected for violation based on the operation rule table as a report on request from a manager.

17. The management system according to Claim 1, wherein
the completion database stores member characteristics of the completion member,
the environment database stores environment characteristics of the environment conditions,
the rule database stores related member characteristics of the related member, and
the operation rule creating unit creates the member list of the operation rule table from member characteristics.

18. A management program describing the management method according to any one of Claims 2, 4, 5, 7, 9, 10, and 12 as a computer program and enabling execution of the computer program.
